# FASCICULE DE BREVET EUROPEEN

(11) **EP 1 695 390 B1**
(45) Date de publication et mention de la délivrance du brevet: **21.11.2018**
(21) Numéro de dépôt: 04804717.9
(22) Date de dépôt: 07.12.2004
(51) Int. Cl.: H01L 31/0236, H01L 31/0352

(54) **PHOTO-DETECTEUR A CONCENTRATION DE CHAMP PROCHE**
FOTODTEKTOR MIT NAHFELDKONZENTRATION
PHOTODETECTOR HAVING A NEAR FIELD CONCENTRATION

(30) Priorité: 16.12.2003 FR 0314717
(43) Date de publication de la demande: 30.08.2006
(73) Titulaire: SOFRADIR, 92290 Châtenay Malabry (FR)
(72) Inventeur: DE ROSSI, Alfredo, THALES Intellectual Property, 94117 Arcueil Cedex (FR); CARRAS, Mathieu, THALES Intellectual Property, 94117 Arcueil Cedex (FR); BOIS, Philippe, THALES Intellectual Property, 94117 Arcueil Cedex (FR)
(74) Mandataire: Cabinet Laurent & Charras
(86) Numéro de dépôt international: PCT/EP2004/053324
(87) Numéro de publication internationale: WO 2005/069385

(56) Documents cités:
- US-A- 5 677 544
- US-A- 5 969 375
- DMITRUK N L ET AL: "Ultraviolet responsivity control in Schottky barrier heterostructures with textured interface" THIN SOLID FILMS, ELSEVIER-SEQUOIA S.A. LAUSANNE, CH, vol. 364, no. 1-2, mars 2000 (2000-03), pages 280-283, XP004195111 ISSN: 0040-6090

## Description

Le domaine de l'invention est celui des photo-détecteurs et plus précisément des photo-détecteurs dits à puits quantiques, connus sous l'acronyme anglo-saxon QWIP signifiant Quantum Well Infrared Photodetector fonctionnant dans le moyen infra-rouge.

Afin d'améliorer les performances des détecteurs, il est nécessaire d'optimiser leur détectivité, c'est-à-dire le rapport entre la réponse du détecteur et le bruit. Lorsque le bruit photonique est négligeable, le bruit total est proportionnel à la racine carrée de l'aire de la zone électriquement active du détecteur. La réponse est, quant à elle, proportionnelle au flux de lumière absorbée. A flux absorbé constant, il faut donc diminuer l'aire de la zone d'absorption pour améliorer la détectivité. De la même façon, le courant d'obscurité est proportionnel à l'aire de la zone active. Dans les systèmes d'imagerie où le courant d'obscurité limite les performances du circuit de lecture, il est donc également important de réduire la taille de l'aire de la zone active pour accroître les performances.

Lorsqu'on utilise un détecteur unique, pour réduire l'aire de la zone active tout en conservant le flux, on peut, par exemple, focaliser la lumière sur un détecteur de taille D avec une lentille de diamètre φ largement supérieur à D, on obtient alors une amélioration du rapport signal/bruit d'une quantité égale à $\sqrt{φ / D .}$ . Le rapport signal/courant d'obscurité est également amélioré d'un facteur φ/D. Cette solution n'est pas applicable en l'état à une matrice de détecteurs.

L'objet de l'invention est d'obtenir une concentration de l'énergie lumineuse sur un surface réduite du détecteur en exploitant des phénomènes de localisation du champ proche et les propriétés de certaines ondes de surface appelées plasmons de surface, la localisation étant obtenue au moyen de structures optiques disposées au voisinage de la surface active du détecteur. On améliore ainsi de façon importante la détectivité du détecteur.

Il est connu de la publication scientifique "Ultraviolet responsivity control in Schottky barrier heterostructures with textured interface" N.L. Dmitruk et al., Thin Solid Films 364 pages 280-283 (2000) d'utiliser un réseau de diffraction sur un détecteur par face avant. Ce réseau de diffraction comporte une couche de métal recouvrant une surface structurée. Cependant, ce détecteur nécessite une épaisseur de métal très faible, de 10 à 20 nm, pour laisser passer les rayonnements. La solution présentée dans cette publication n'est pas applicable au problème posé car elle ne permet pas d'obtenir la fonction de concentration du rayonnement incident.

L'invention s'applique avantageusement aux détecteurs à puits quantiques. En effet, ces détecteurs nécessitent naturellement un réseau de diffraction excitant une onde polarisée de type Transverse Magnétique, permettant l'absorption de l'onde incidente par les puits quantiques. Dans ce cas, il suffit de modifier la structure du réseau pour obtenir à la fois l'absorption et la concentration de l'énergie lumineuse incidente.

Cette invention qui utilise des structures métalliques est bien adaptée au domaine infrarouge. En effet, dans ce domaine spectral, les structures métalliques sont particulièrement efficaces dans la mesure où elles présentent à la fois de faibles pertes et une forte interaction avec le champ électro-magnétique.

Enfin, la concentration du champ peut être effectuée soit dans une dimension de l'espace au moyen d'une structure composée de sillons parallèles, soit dans les deux dimensions de l'espace au moyen d'une structure bidimensionnelle.

Plus précisément, l'invention a pour objet un photo-détecteur dont les caractéristiques font l'objet de la revendication 1 comprenant au moins une zone active de détection du rayonnement optique et une structure disposée sur ladite zone active destinée au couplage optique du rayonnement optique, caractérisé en ce que la zone active est de forme allongée et que la dite structure est composée de sillons parallèles entre eux et parallèles à la longueur de la zone active. La structure est réalisée dans une couche d'au moins un matériau diélectrique transparent dans la plage spectrale du rayonnement optique, ladite couche comprenant une face inférieure sensiblement plane en contact avec la zone active et une face supérieure comportant les sillons de la structure, ladite face recouverte d'une pellicule de métal, l'épaisseur optique de la dite couche séparant la face inférieure de la face supérieure selon un axe perpendiculaire à la direction des sillons et parallèle au plan de la face inférieure varie comme la superposition au moins d'un premier réseau dit de couplage dont le pas est à une première fréquence spatiale et d'un second réseau dit de localisation dont le pas est à une seconde fréquence spatiale double de la première fréquence spatiale et comportant un défaut spatial central.

Elle a également pour objet un photo-détecteur dont les caractéristiques font l'objet de la revendication 10 comprenant au moins une zone active de détection du rayonnement optique et une structure disposée sur ladite zone active destinée au couplage optique du rayonnement optique, caractérisé en ce que ladite structure bidimensionnelle est composée de motifs de dimensions sensiblement identiques, que la zone active est centrée sur ladite structure et que les dimensions de la zone active sont sensiblement égales aux dimensions moyennes des motifs. Avantageusement, lorsque la couche constituant la structure est réalisée dans un matériau diélectrique isotrope, chaque motif est composé de facettes planes de hauteur différente et parallèles entre elles, les dimensions des motifs de la structure sont environ égales à la moitié de la longueur d'onde moyenne du rayonnement incident divisé par l'indice optique moyen de la structure et la zone active est entourée d'une zone optiquement passive de dimensions sensiblement égales à celles de la structure. La structure est réalisée dans une couche d'au moins un matériau diélectrique transparent dans la plage spectrale du rayonnement optique, ladite couche comprenant une face inférieure sensiblement plane en contact avec la zone active et une face supérieure comportant les motifs de la structure, ladite face recouverte d'une pellicule de métal, l'épaisseur optique de la dite couche séparant la face inférieure de la face supérieure varie :
- selon un premier axe parallèle au plan de la face inférieure, comme au moins un premier réseau dont le pas est à une première fréquence spatiale ;
- selon un second axe perpendiculaire au premier axe et parallèle au plan de la face inférieure, comme au moins un second réseau dont le pas est à la même première fréquence spatiale ;
- selon un troisième axe oblique à 45 degrés des deux précédents, comme au moins un troisième réseau dont le pas est à une seconde fréquence spatiale égale à la moitié de la première fréquence spatiale.

L'invention sera mieux comprise et d'autres avantages apparaîtront à la lecture de la description qui va suivre donnée à titre non limitatif et grâce aux figures annexées parmi lesquelles :
- la figure 1 représente la courbe de dispersion des plasmons de surface dans le cas d'une interface entre deux milieux de permittivité différente ;
- la figure 2 représente la courbe de dispersion des ondes se propageant dans un milieux périodique ;
- la figure 3 représente la distribution du champ électrique et du profil de la permittivité correspondant aux points ω₋ et ω₊ de la figure 2 ;
- la figure 4 représente la courbe de dispersion des ondes se propageant dans un milieu périodique de longueur L ;
- la figure 5 représente la distribution du champ électrique pour le premier ordre (δ=π/L) et le deuxième ordre (δ=2π/L) des modes représentés en figure 4 ;
- la figure 6 représente la distribution du champ électrique et le profil de la permittivité dans le cas d'un milieu périodique comportant un défaut Δx égal à +λ/4 ;
- la figure 7 représente la distribution du champ électrique et le profil de la permittivité dans le cas d'un milieu périodique comportant un défaut Δx égal à -λ/4 ;
- la figure 8 représente une vue en coupe d'un détecteur comportant une structure à sillons selon l'invention ;
- la figure 9 représente la distribution du champ électrique et le profil de la structure à sillons dans un premier mode de réalisation selon l'invention ;
- la figure 10 représente la distribution du champ électrique et le profil de la structure à sillons dans un second mode de réalisation selon l'invention ;
- la figure 11 représente la transformée de Fourier du profil de la structure dans le premier mode de réalisation selon l'invention ;
- la figure 12 représente la transformée de Fourier du profil de la structure dans le second mode de réalisation selon l'invention ;
- les figures 13 et 14 représentent un profil de structure dans un troisième mode de réalisation selon l'invention et sa transformée de Fourier ;
- la figure 15 représente deux profils réels de la structure à sillons dans ledit premier mode de réalisation selon l'invention ;
- la figure 16 représente deux profils réels de la structure à sillons dans ledit second mode de réalisation selon l'invention ;
- la figure 17 représente une vue en coupe de la structure à sillons selon le premier mode de réalisation selon l'invention ;
- la figure 18 représente une vue en coupe de la structure à sillons selon un mode particulier de réalisation selon l'invention,
- la figure 19 représente l'intensité optique relative en fonction de la longueur d'onde pour un profil de structure selon le premier mode de réalisation selon l'invention ;
- la figure 20 représente l'intensité relative en fonction de la distance au centre de la structure selon le premier mode de réalisation ;
- la figure 21 représente l'intensité relative en fonction de la longueur d'onde pour un profil de réseau de Bragg bi-périodique ;
- la figure 22 représente l'intensité relative en fonction du profil de réseau de la figure 21 ;
- la figure 23 représente une vue éclatée d'un détecteur comportant une structure bidimensionnelle selon l'invention ;
- la figure 24 représente une vue de dessus et deux vues en coupe d'une première fonction constituant en partie une structure bidimensionnelle selon l'invention ;
- la figure 25 représente une vue de dessus et deux vues en coupe de la fonction constituant la structure bidimensionnelle selon l'invention.

L'invention repose sur les propriétés des plasmons de surface en interaction avec des réseaux ou des structures de diffraction optiques.

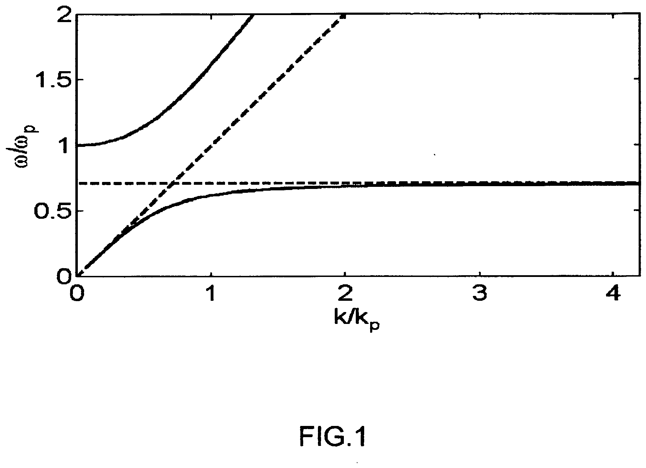

Un plasmon de surface est une onde de surface se propageant à l'interface entre deux milieux dont les permittivités diélectriques sont de signe opposé, la somme des permittivités étant elle-même négative. C'est le cas, par exemple, des interfaces entre un milieu conducteur qui peut être un métal ou un matériau semi-conducteur dopé et un milieu diélectrique. On démontre que les plasmons de surface existent au-dessous de la fréquence de résonance du plasma. Classiquement, une onde optique est définie par la propagation d'un champ électromagnétique caractérisé par une pulsation ω, caractéristique de sa variation temporelle et un vecteur d'onde k caractéristique de sa variation spatiale. On démontre que la pulsation et le vecteur d'onde d'une onde susceptible de se propager à l'interface entre deux milieux de ce type vérifie une des deux courbes de la figure 1 où ω_{P} représente respectivement la fréquence de plasma et où k_{P} vaut ω_{P}/c avec c vitesse de la lumière. On démontre que les plasmons de surface n'existent qu'au-dessous de la fréquence de résonance du plasma et par conséquent, seule la courbe inférieure est représentative des plasmons de surface.

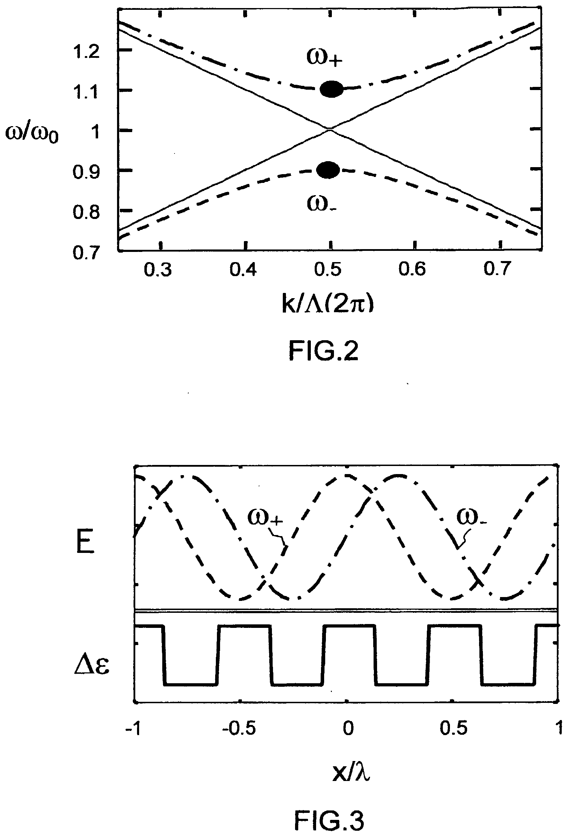

Dans les milieux où l'indice de réfraction est modulé périodiquement, on démontre qu'il existe des plages spectrales ou la lumière ne peut pas se propager que l'on appelle « bandes interdites photoniques ». Par exemple, la figure 2 représente une bande interdite dans le cas d'un milieu périodique de pas Λ et dont la variation d'indice est caractérisée par la modulation de la constante diélectrique Δε(x) qui vaut Δε cos(2π *x*/Λ) dans une direction x perpendiculaire aux sillons du réseau de la figure 2. L'abscisse sur la figure 2 représente les vecteurs d'onde k normalisés par rapport au pas Λ du réseau périodique. L'ordonnée représente la pulsation ω normalisée par rapport à une pulsation ω_{O} valant c/2Λ. La bande interdite est comprise entre la branche inférieure et la branche supérieure de la figure 2. Elle est centrée en ω_{O} et en k_{O} égal à Λ/2. On appelle ω₊ et ω₋ les pulsations correspondant à k_{O} prises en limite de bande interdite. On pose ω₋ égale à ω₀ - Δω et ω₊ égale à ω₀ + Δω. La largeur minimale Δω correspondant à la différence entre ω₊ et ω vaut $c Δε / 2 Λ \sqrt{ε .}$ En dehors des bandes interdites, les ondes électromagnétiques qui se propagent s'appellent modes de « Bloch » et sont le produit d'un terme strictement périodique et d'un terme de phase dont le vecteur d'onde δ s'annule au bord de la bande interdite. Dans le cas de la figure 2, la distribution des champs E₊ et E₋ correspondant aux pulsations ω₊ et ω₋ sont proportionnelles respectivement à sin(π *x*/Λ)*e*^{±*iδx*} et cos(π *x*/Λ)*e*^{±*iδx*}. Lesdites distributions de E+ et de E- sont représentées sur la figure 3 en fonction du paramètre x/λ, la variation de la constante diélectrique est également représentée sur cette même figure.

Les plasmons de surface vérifient également ces propriétés lorsque le milieu dans lequel ils se propagent est modulé périodiquement. Ils prennent alors les propriétés d'ondes de Bloch. Le plasmon se propage suivant l'interface entre le diélectrique et le métal. On peut réaliser la modulation de l'indice optique de deux façons. La première consiste à faire varier périodiquement la permittivité du milieu diélectrique. La deuxième consiste à réaliser une interface métal/diélectrique sous forme de réseau. En particulier, on peut montrer qu'un réseau dont le profil h(x) suit la loi *h*₀ cos(2π *x*/Λ), h₀ étant une constante, équivaut à une modulation de la permittivité diélectrique Δε(x) égale à Δε cos(2π *x*/Λ) (W. L. Barnes, T. W. Presist, S. C. Kitson, and J. R. Sambles, "Physical Origin of photonic energy gaps in the propagation of surface plasmons on gratings," Physical Review B, vol. 54, pp. 6227-6244, 1996.).

Dans un réseau de taille finie, il existe des résonances de type Fabry-Pérot dues à la réflexion des plasmons aux extrémités du réseau. La distribution du champ, toutefois, est différente de celle d'une cavité Fabry-Pérot dans un milieu homogène. Soit L la longueur du réseau et δ un paramètre valant (k-π/Λ), alors la condition de résonance s'écrit :
δ*L*=*p*π, p étant un nombre entier

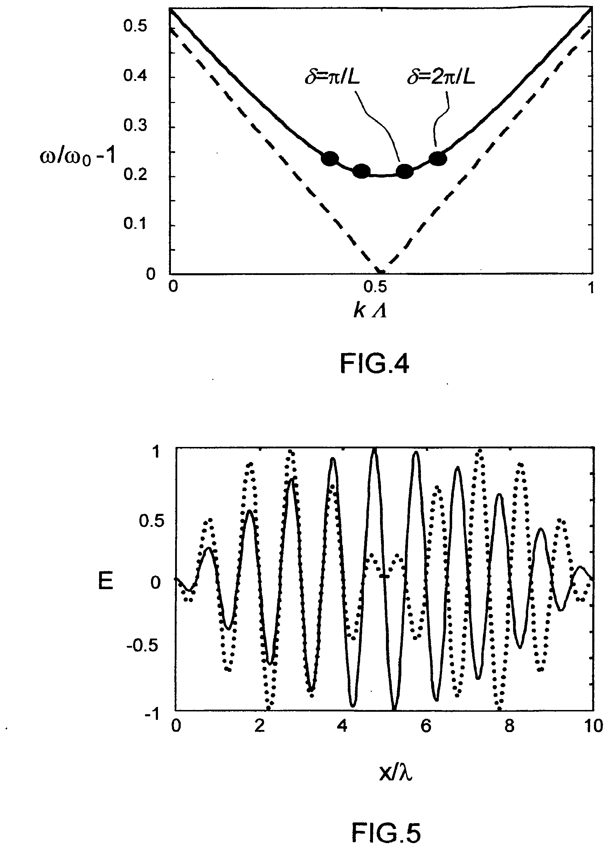

Cette condition peut être satisfaite à partir de p égal à 1, même si la longueur du réseau L est très supérieure à la longueur d'onde λ de l'onde plasmonique. La figure 4 représente la courbe de dispersion des plasmons de surface pour un réseau de type Fabry-Pérot dans le cas particulier où L est égal à dix fois la longueur d'onde. Sur cette figure 4, le paramètre kΛ est en abscisse et le paramètre (ω/ω_{O} -1) en ordonnée. Les points noirs correspondent aux valeurs de kΛ et de (ω/ω_{O} -1) pour différentes valeurs de p. Lorsque p est égal à 1, le champ E est localisé au milieu du réseau comme indiqué sur la figure 5. Dans ce cas, le champ E vaut E₊ pour ω₊ = ω₀ + Δω et est proportionnel à sin(π *x*/Λ)sin(δ*x*) et E. pour ω₊ = ω₀ - Δω et est proportionnel à cos(π *x*/Λ)sin(δ*x*). Ce phénomène a été prédit pour des plasmons de surface dans des réseaux métalliques (F. Pincemin and J.-J. Greffet , "Propagation and localization of a surface plasmon polariton on a finite grating," Journal of the Optical Society of America B, vol. 13, pp. 1499-1509, 1996). Sur la figure 5, le champ E dans le cas où p est égal à 2 a également été représenté en pointillés.

Lorsqu'une structure périodique est perturbée, par exemple, si l'on introduit un défaut qui peut être par exemple un déphasage ou un changement local de l'indice de réfraction, un mode localisé apparaît autour du défaut. L'énergie de ce niveau se situe alors dans la bande interdite. A titre d'exemple, soit une modulation de l'indice décrite par sa variation de permittivité : Δε(***x***) = Δε ***cos***(2π(|***x***|- Δ***x***)/Λ) = ±Δε ***sin***(2π|***x***|/Λ) en adoptant les mêmes conventions que précédemment. Dans la limite où Δε(***x***) est une perturbation, le champ du mode localisé peut s'écrire de la manière suivante : $E \left(x\right) = { \begin{matrix}{e}^{- γ x} cos \left(k \left(x - Δ x / 2\right) - π / 4\right) & x > 0 \\ {e}^{γ x} cos \left(k \left(x + Δ x / 2\right) + π / 4\right) & x < 0\end{matrix}$ Où k=2πn/λ=π/Λ. Le déphasage Δx peut prendre deux valeurs : ±Λ/8 =±λ/4n à un multiple de Λ/4 près, n étant l'indice de réfraction du réseau.

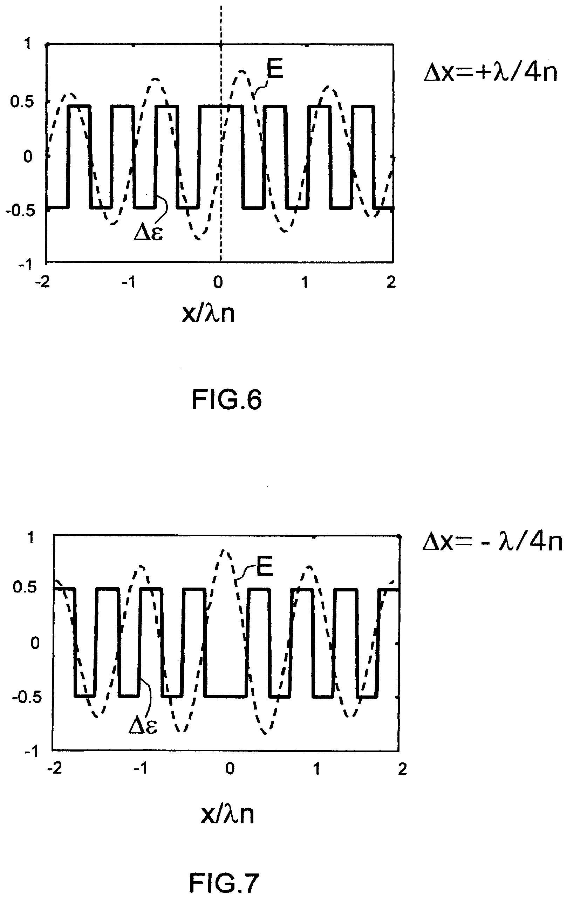

La décroissance du champ est liée au terme γ égal à $k Δε/4 \sqrt{ε .}$ On montre que la distribution du champ conserve les propriétés de symétrie. De plus les positions des extrêmes du champ E par rapport au réseau ne changent pas. Sur les figures 6 et 7 sont représentées en pointillés la distribution du champ E et en traits continus le profil de la variation de permittivité en fonction de la direction x perpendiculaire à la direction des sillons du réseau pour deux valeurs du déphasage qui sont respectivement égaux à +λ/4n et -λ/4n.

Les plasmons de surface sont situés au-dessous de la « ligne de lumière » comme on le voit sur la figure 1 où elle est figurée par la diagonale en pointillés et ne peuvent pas être excités sans l'aide d'un prisme ou d'un réseau de couplage. Les propriétés des plasmons de surface qui sont excités par un réseau métallique de couplage *k₁* égal à 2π/Λ₁, Λ₁ étant le pas du réseau et qui interagissent avec un réseau de Bragg de couplage *k₂* égal à π/Λ₂ ont été étudiées. (W. L. Barnes, T. W. Presist, S. C. Kitson, and J. R. Sambles, "Physical Origin of photonic energy gaps in the propagation of surface plasmons on gratings," Physical Review B, vol. 54, pp. 6227-6244, 1996.). Dans ce cas, le profil h(x) du réseau est, en se limitant aux termes du premier ordre de la série de Fourier correspondant au profil du réseau : $h \left(x\right) = {a}_{1} cos \left(2 π x / {Λ}_{1}\right) + {a}_{2} cos \left(2 π x / {Λ}_{2} + Φ\right) .$

Dans un réseau métallique, c'est la charge de surface générée par l'onde incidente qui dévient la source de l'onde de surface excitée. On trouve alors que la charge σ_{S}(x) est proportionnelle à *a*₁ sin(2π*x*/Λ₁). Puisque le couplage dépend de la superposition entre la charge et le mode de Bloch, la phase relative φ détermine la branche excitée permettant la propagation des modes de Bloch comme indiqué sur la figure 2. Si φ est égal à π, la branche inférieure ω⁻ est excitée, si φ est nul, la branche ω⁺ est excitée.

Il est donc possible en cumulant les propriétés des réseaux de couplage et des réseaux de Bragg présentant au moins un défaut d'obtenir à partir d'une onde incidente une onde plasmonique qui soit à la fois couplée et localisée dans une région de dimensions petites par rapport à celles de la structure finale et par conséquent d'améliorer de façon importante la détectivité d'un détecteur comportant une telle structure. Cette disposition peut s'appliquer à des structures de type monodimensionnel, c'est-à-dire dont le profil ne varie que dans une seule direction de l'espace, dans ce cas, l'onde est localisée dans une bande étroite centrale parallèle à la direction des sillons. Elle s'applique également à des structures de type bidimensionnel, c'est-à-dire dont le profil varie dans les deux dimensions de l'espace, dans ce cas, l'onde est localisée au centre du réseau dans une zone de dimensions étroites par rapport aux dimensions du réseau.

### Cas des photo-détecteurs à réseau monodimensionnel

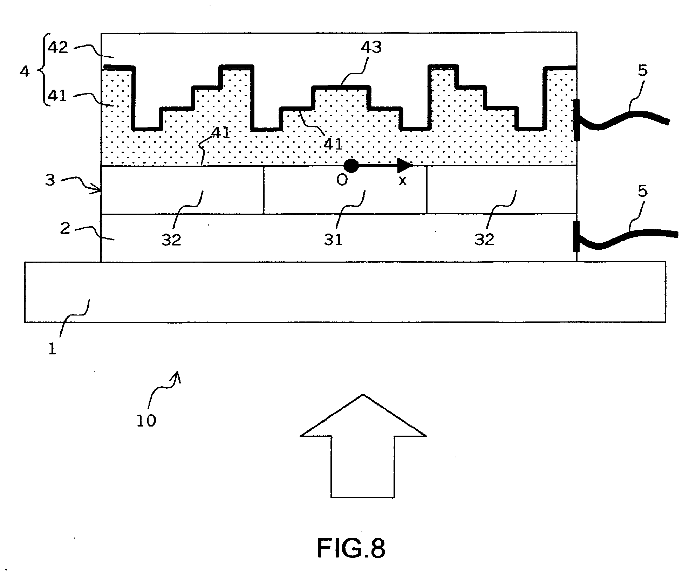

Dans ce cas, un photo-détecteur 10 selon l'invention comprend essentiellement comme il est indiqué sur la figure 8:
- Un premier substrat 1 support du photo-détecteur transparent au rayonnement optique que l'on cherche à détecter;
- Une première couche 2 conductrice également transparente;
- Une seconde couche 3 composée de la zone active 31 proprement dit qui a la forme d'une bande étroite et de deux zones périphériques 32 inactives à la lumière et disposées de part et d'autre de la zone active, au moins les zones inactives également transparentes ;
- La structure 4 selon l'invention.
- Des zones de contacts électriques 5 permettant de capter le signal électrique issu de la zone active.

Comme il est indiqué sur la figure 8, la structure 4 selon l'invention comprend essentiellement une couche 41 d'au moins un matériau diélectrique transparent dans la plage spectrale du rayonnement optique, ladite couche 41 comprenant une face inférieure 410 sensiblement plane en contact avec la zone active et une face supérieure 411 comportant les sillons de la structure, ladite face recouverte d'une pellicule de métal 43 représentée en traits gras sur la figure 8. A titre d'exemple non limitatif, le métal est de l'or ou du palladium. L'épaisseur de ladite couche de métal est de quelques nanomètres. L'épaisseur optique de la dite couche séparant la face inférieure de la face supérieure varie , selon un axe perpendiculaire Ox à la direction des sillons et parallèle au plan de la face inférieure, comme la superposition au moins d'un premier réseau dont le pas est à une première fréquence spatiale et d'un second réseau dont le pas est à une seconde fréquence spatiale double de la première fréquence spatiale. Une seconde couche de matériau diélectrique 42 assure la protection de la structure.

Le fonctionnement du photo-détecteur est le suivant. Un faisceau de lumière (flèche épaisse de la figure 8) éclaire le photo-détecteur sous une incidence voisine de la normale. Ce faisceau passe à travers le premier substrat 1, la première couche conductrice 2 et la seconde couche 3 sans atténuations sensibles. Il atteint alors la structure 4. Comme il a été dit, la structure est l'union d'un réseau de couplage, dont le but est l'excitation d'une onde de surface en polarisation transverse magnétique, c'est-à-dire dont le champ électrique est perpendiculaire au réseau, avec un réseau de Bragg avec défaut, afin d'obtenir une localisation du faisceau lumineux capturé par la structre dans une zone centrale correspondant à la zone active 31. On améliore ainsi le rapport signal à bruit, ce qui est le but recherché.

Si l'on définit un axe Ox perpendiculaire à la direction des sillons et parallèle au plan de la face inférieure du réseau 4, la fonction mathématique définissant l'épaisseur optique R(x) de la structure est, à une constante près, la somme de deux fonctions périodiques g(x,Λ) et f(x,2Λ), f représentant la fonction de couplage de période spatiale Λ et g représentant la fonction de Bragg de localisation de période spatiale 2Λ comportant un défaut central. La phase relative entre f et g conditionne les propriétés finales de confinement de l'onde couplée. Si on note λ la longueur d'onde moyenne du rayonnement incident, avantageusement, le pas Λ doit être environ égal à λ/2n pour obtenir un couplage optimal de l'onde d'incidence.

On démontre qu'il existe deux familles de profils de structures possibles, l'une excitant un mode anti-symétrique et l'autre un mode symétrique.

Dans le cas du mode anti-symétrique, les fonctions f_{AS} et g_{AS} sont alors sous la forme : ${f}_{AS} \left(x\right) = \pm {a}_{1} cos \left(2 π x / Λ\right)$ ${g}_{AS} \left(x\right) = - {a}_{2} cos \left(4 π | x | / Λ−π/2\right)$ a₁ et a₂ sont deux constantes positives.

Autrement dit, l'épaisseur R(x) de la couche séparant la face inférieure de la face supérieure varie à une constante près, selon un axe perpendiculaire à la direction des sillons, parallèle au plan de la face inférieure et dont l'origine est centrée sur le centre de la structure, comme une fonction qui est la somme ou la différence :
- d'une première fonction proportionnelle à la fonction signe de la fonction cosinus de la distance à l'origine dudit axe et de période égale à celle du pas des sillons ;
- d'une seconde fonction proportionnelle à la fonction signe de la fonction cosinus de la valeur absolue de la distance à l'origine dudit axe, de période égale à la moitié de celle du pas des sillons, ladite seconde fonction déphasée d'une demi-période par rapport à la première fonction.

Avantageusement, le coefficient de proportionnalité de la première fonction est le double de celui de la deuxième fonction et le pas du premier réseau de la structure est environ égal à la moitié de la longueur d'onde moyenne du rayonnement incident divisé par l'indice optique moyen de la structure.

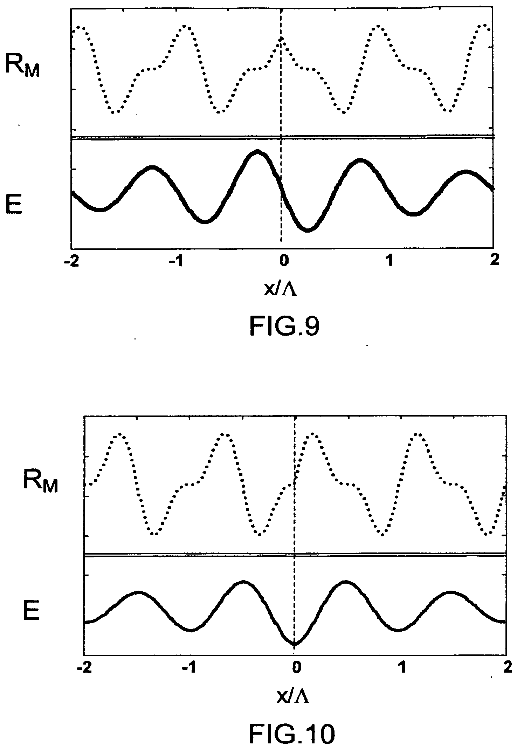

Dans ce cas, on démontre que l'amplitude complexe E(x) de l'onde couplée vaut e^{-γ|*x*|} sin(2π *x*/λ) correspondant à un mode localisé. γ est une constante de décroissance du champ dépendant des paramètres du réseau. Le champ électrique E(x) et le profil R_{M} de la structure monodimensionnelle dans ce mode de réalisation anti-symétrique sont représentés en fonction de x/Λ pour a₂ égal à la moitié de a₁ sur la figure 9.

Dans le cas du mode symétrique, les fonctions f_{S} et g_{S} sont alors sous la forme : ${f}_{S} \left(x\right) = \pm {a}_{1} sin \left(2 πx / Λ\right)$ ${g}_{S} \left(x\right) = {a}_{2} cos \left(4 π | x | / Λ - π / 2\right)$ a₁ et a₂ sont deux constantes positives.

Autrement dit, l'épaisseur optique de la couche séparant la face inférieure de la face supérieure varie, selon un axe perpendiculaire à la direction des sillons, parallèle au plan de la face inférieure et dont l'origine est centrée sur le centre de la structure, comme une fonction qui est la somme ou la différence :
- d'une première fonction proportionnelle à la fonction signe de la fonction sinus de la distance à l'origine dudit axe et de période égale à celle du pas des sillons ;
- d'une seconde fonction proportionnelle à la fonction signe de la fonction cosinus de la valeur absolue de la distance à l'origine dudit axe, de période égale à la moitié de celle du pas des sillons, ladite seconde fonction déphasée d'une demi-période par rapport à la première fonction.

Dans ce cas, on démontre que l'amplitude complexe E(x) de l'onde couplée vaut *e*^{-γ|*x*|} cos(2π *x*/λ) correspondant à un mode localisé. γ est une constante de décroissance du champ dépendant des paramètres du réseau. Le champ électrique E(x) et le profil R_{M} de la structure monodimensionnelle dans ce mode de réalisation anti-symétrique sont représentés en fonction de x/Λ pour a₂ égal à la moitié de a₁ sur la figure 10. Le choix du poids respectif des fonctions f et g est déterminé par l'optimisation du champ proche qui dépend de l'application envisagée. Il n'y a aucune restriction précise sur la profondeur de couplage, ni sur le poids relatif des deux fonctions.

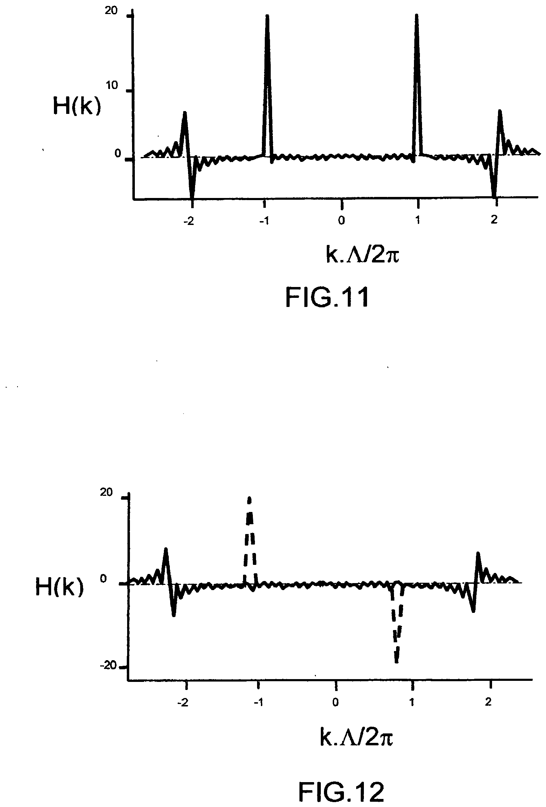

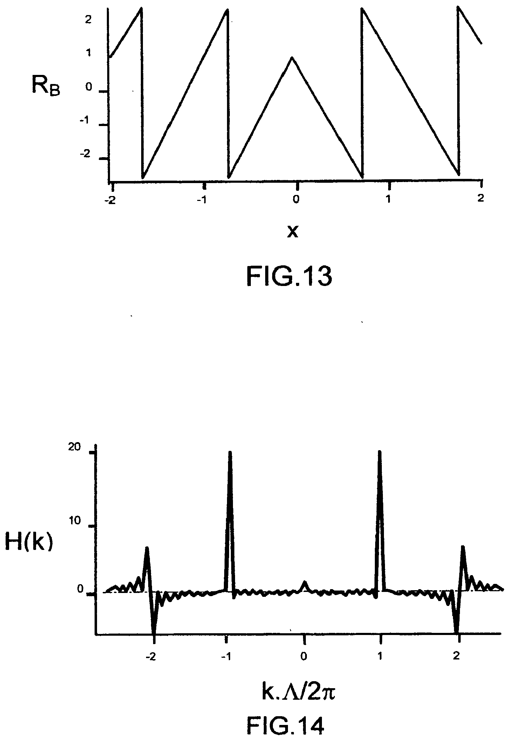

Technologiquement, les réseaux de couplage utilisés dans les détecteurs infrarouges sont réalisés par gravure de la couche puis dépôt métallique. La réalisation technique des profils de structure selon des fonctions continues de type f et g posent des problèmes de réalisation complexes sans procurer d'avantages significatifs au niveau des rendements lumineux. Les propriétés de couplage et de localisation de la structure sont déterminées par la transformée de Fourier de la fonction représentative de l'épaisseur optique de la structure pour une valeur de k comprise dans la plage [- 4π/Λ, + 4π/Λ]. Les figures 11 et 12 représentent les transformées de Fourier H(k) en fonction de kΛ/2π des modes antisymétriques et symétriques tels qu'ils sont définis précédemment. Les courbes pleines représentent les parties réelles des transformées de Fourier et les courbes en pointillés représentent les parties imaginaires desdites transformées de Fourier. Dans le cas du mode anti-symétrique de la figure 11, on obtient au voisinage des valeurs de KΛ/2π égales à +1 et à -1 deux pics réels et symétriques et au voisinage des valeurs de KΛ/2π égales à +2 et à -2 deux doubles pics, chacun antisymétrique et réel et symétriques par rapport à l'origine. Dans le cas du mode symétrique de la figure 12, on obtient au voisinage des valeurs de KΛ/2π égales à +1 et à -1 deux pics imaginaires purs de signe opposé et deux doubles pics réels au voisinage des valeurs de KΛ/2π égales à +2 et à -2. Si l'on choisit un profil très différent des profils sinusoïdaux mais comportant les mêmes fréquences fondamentales, alors les fonctions fondamentales de couplage et de localisation sont assurées. En figures 13 et 14, un profil de structure de type « blazé » R_{B} est représenté avec sa transformée de Fourier. Les réseaux blazés sont utilisés pour maximiser la diffraction des ondes lumineuses dans un seul ordre et ont généralement un profil caractéristique en dent de scie. On note que la transformée de Fourier représentée en figure 14 est très voisine de la transformée de Fourier représentée en figure 11. On en déduit que les propriétés de couplage et de confinement de ce profil sont équivalentes à celles de la structure monodimensionnelle excitant le mode anti-symétrique représenté en figure 9, bien que les profils initiaux soient sensiblement différents.

Technologiquement, les structures simples à réaliser sont constituées de « marches d'escalier » ou de facettes obtenues par l'empilement de couches successives. On peut ainsi obtenir le profil souhaité en deux ou en trois étapes de gravure. Ce type de profil a des propriétés équivalentes à celles des réseaux sinusoïdaux à condition, bien entendu, qu'il comporte deux fréquences spatiales fondamentales, l'une étant la double de l'autre. Mathématiquement, pour obtenir ce type de profil, on peut remplacer les fonctions f et *g* par les fonctions *signe(f)* et *signe(g)* qui vérifient les propriétés suivantes :
- quand la fonction est positive, la fonction signe vaut +1
- quand elle est négative, elle vaut -1.

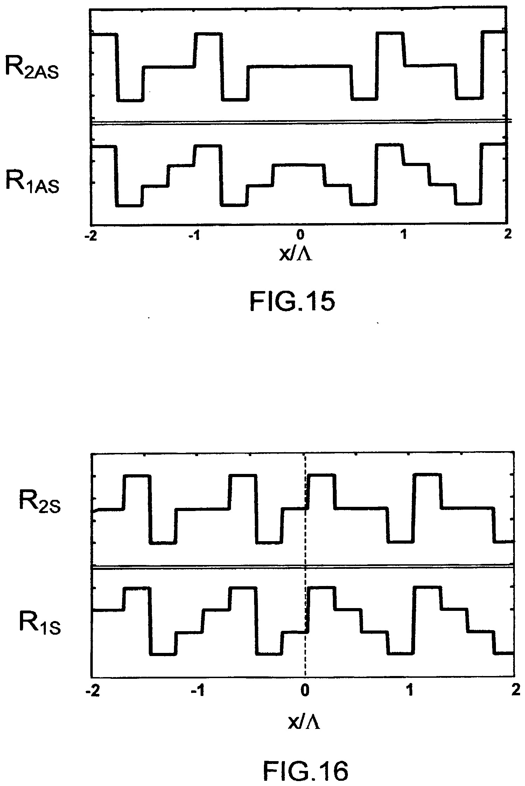

Ainsi, les figures 15 et 16 représentent pour les modes anti-symétrique et symétrique les profils suivantes : ${R}_{1 AS} \left(x\right) = signe \left({f}_{AS}\right) + signe \left(\frac{{g}_{AS}}{2}\right)$ ${R}_{2 AS} \left(x\right) = \frac{signe \left({f}_{AS}\right) + signe \left({g}_{AS}\right)}{2}$ ${R}_{1 S} \left(x\right) = signe \left({f}_{S}\right) + signe \left(\frac{{g}_{S}}{2}\right)$ ${R}_{2 S} \left(x\right) = \frac{signe \left({f}_{S}\right) + signe \left({g}_{S}\right)}{2}$

La réalisation technologique de ce type de structure peut se faire de deux façons différentes.

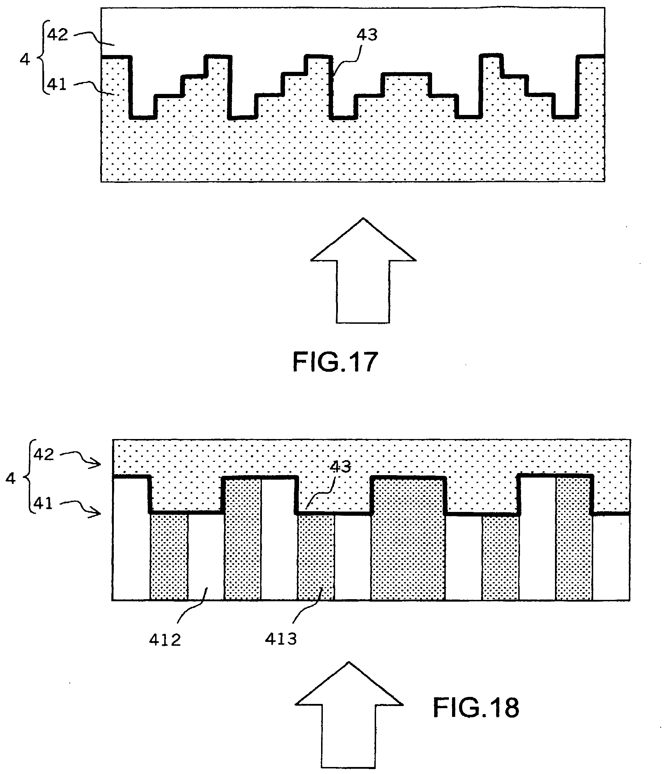

Dans un premier mode de réalisation illustré en figure 17, la couche 41 constituant la structure est réalisée dans un matériau diélectrique isotrope, le profil de chaque sillon selon l'axe perpendiculaire à la direction des sillons est composé de facettes planes de hauteur différente et parallèles entre elles selon un profil du type de ceux des figures 15 et 16. Elle est surmontée d'une couche protectrice 42.

Dans un second mode de réalisation illustré en figure 18, la couche 41 constituant la structure est réalisée dans un matériau composé de couches alternées 412 et 413 parallèles entre elles et de même épaisseur et d'une couche centrale d'épaisseur double correspondant au défaut, lesdites couches comprenant alternativement un premier matériau ayant une première permittivité et un second matériau ayant une seconde permittivité, le plan des couches étant perpendiculaire au plan de la face inférieure et le profil de chaque sillon selon l'axe perpendiculaire à la direction des sillons est composé de créneaux réguliers d'un pas deux fois supérieur à l'épaisseur des couches. Cette disposition permet de simplifier notablement le profil de la face supérieure du réseau qui ne comporte plus alors que deux hauteurs différentes. Le faisceau incident est représenté par une flèche épaisse sur ces deux figures 17 et 18.

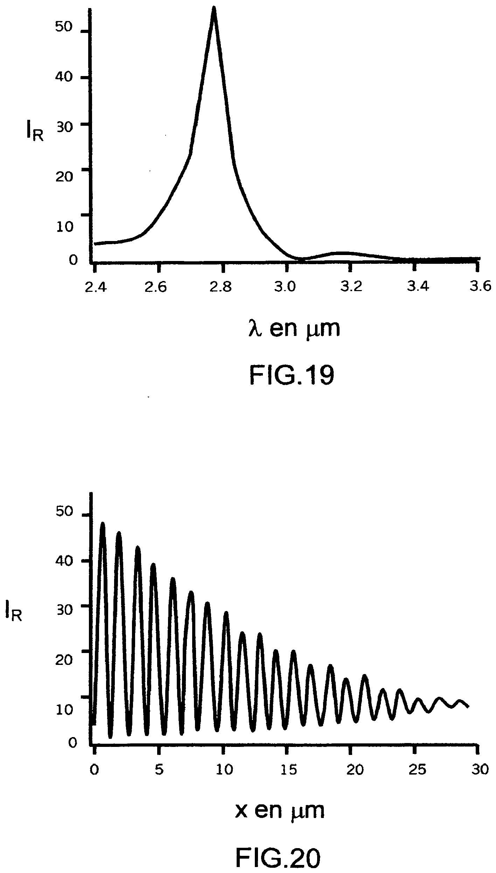

A titre d'exemple, soit une structure métallique du type de celui représenté en figure 17, sa période Λ est de 2.8 microns dans l'air. Le métal de la pellicule qui recouvre la structure est considéré comme étant parfait, c'est-à-dire avec une permittivité infinie. Cette structure est éclairée en incidence normale par une onde plane. La distribution du champ proche excité par la structure est calculée par la méthode des éléments finis. La distributions spatiale de la composante de l'intensité moyenne du champ électrique au-dessous de la structure suivant une direction perpendiculaire au plan moyen du réseau est représentée en figure 20. Le champ proche devient très intense lorsque la longueur d'onde λ de l'onde plane est proche de Λ.n, ce qui est une propriété générale des réseaux réfléchissants. Le champ proche est localisé au milieu du réseau, correspondant à x nul. Au moins 60 pour cent de l'énergie du champ proche est localisée à moins de 10 microns du milieu de la structure, correspondent à une augmentation de l'intensité du champ d'un facteur 3 par rapport à une structure périodique classique. La distributions spectrale de la composante de l'intensité moyenne du champ électrique au-dessous du réseau suivant la longueur d'onde est représentée en figure 19. La largeur spectrale est égale à mi-hauteur de l'intensité à 0.14 micron.

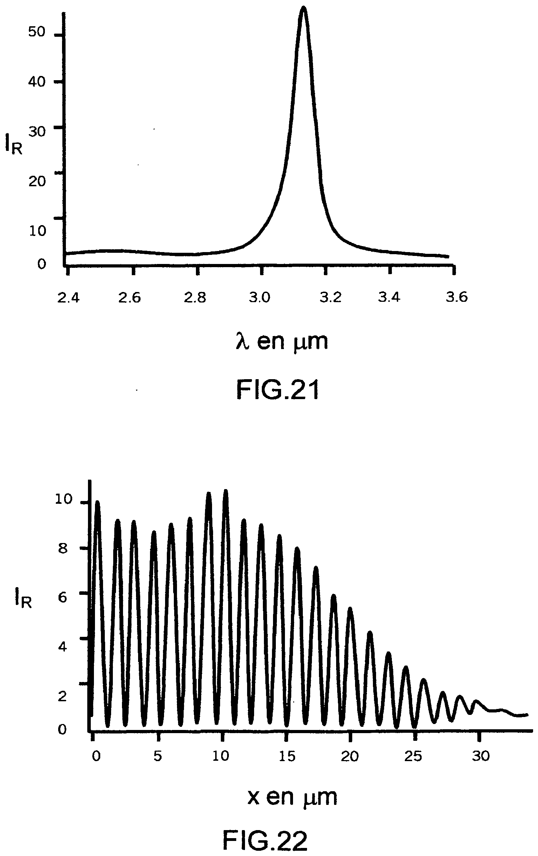

Il est à noter que lorsque la structure ne comporte pas de défaut central, ses propriétés de confinement en sont altérées. Pour comparaison, les figures 21 et 22 présentent des distributions similaires, mais dans le cas de localisation due aux effets de taille finie dans le cas d'un réseau bi-périodique ne présentant pas de défaut central. La localisation spatiale existe mais sur une largeur deux fois plus grande par rapport au cas précédent. De plus, la distribution spectrale s'affine, la largeur spectrale est égale à mi-hauteur de l'intensité à 0.12 micron comme indiqué sur la figure 21.

### Cas des photo-détecteurs à structure bidimensionnelle

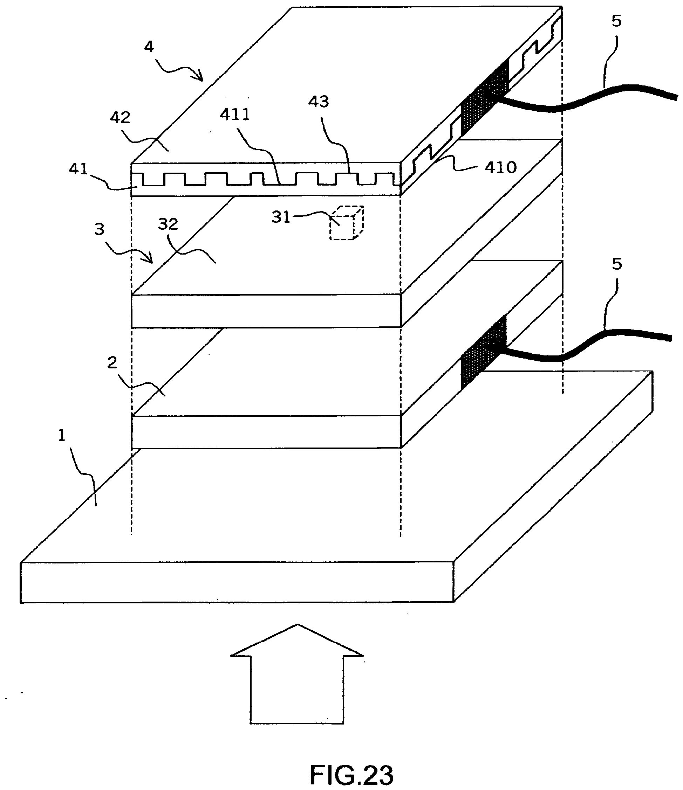

Dans ce cas, un photo-détecteur 10 selon l'invention comprend essentiellement comme il est indiqué sur la vue éclatée de la figure 23:
- Un premier substrat 1 support du photodétecteur transparent au rayonnement optique que l'on cherche à détecter;
- Une première couche 2 conductrice également transparente;
- Une seconde couche 3 composée de la zone active 31 proprement dit qui a la forme d'une zone centrale de petites dimensions entourée d'une zone périphérique inactive 32 à la lumière et disposée autour de la zone active, au moins les zones inactives étant également transparentes ;

- La structure bidimensionnelle 4 selon l'invention ;
- Des zones de contacts électriques 5 permettant de capter le signal électrique issu de la zone de contact.

La structure bidimensionnelle est composée de motifs de dimensions sensiblement identiques, la zone active 31 est centrée sur la structure et les dimensions de la zone active sont sensiblement égales aux dimensions moyennes des motifs.

La structure est réalisée dans une couche d'au moins un matériau diélectrique 41 transparent dans la plage spectrale du rayonnement optique, ladite couche comprenant une face inférieure 410 sensiblement plane en contact avec la zone active et une face supérieure 411 comportant les motifs de la structure, ladite face recouverte d'une pellicule de métal 43, l'épaisseur optique de la dite couche séparant la face inférieure de la face supérieure varie :
- selon un premier axe parallèle au plan de la face inférieure, comme au moins d'un premier réseau dont le pas est à une première fréquence spatiale ;
- selon un second axe perpendiculaire au premier axe et parallèle au plan de la face inférieure, comme au moins d'un premier réseau dont le pas est à la même première fréquence spatiale ;
- selon un troisième axe oblique à 45 degrés des deux précédents, comme au moins un troisième réseau dont le pas est à une seconde fréquence spatiale égale à la moitié de la première fréquence spatiale.

Le fonctionnement du photo-détecteur est le suivant. Un faisceau de lumière (flèche épaisse de la figure 23) éclaire le photo-détecteur sous une incidence voisine de la normale. Ce faisceau passe à travers le premier substrat 1, la première couche 2 conductrice et la seconde couche 3 sans atténuations sensibles. Il atteint alors la structure bidimensionnelle 4. Comme il a été dit, ladite structure est l'union d'un réseau de couplage, dont le but est l'excitation d'une onde de surface en polarisation transverse magnétique, c'est-à-dire dont le champ électrique est perpendiculaire au réseau, avec un réseau de Bragg avec défaut, afin d'obtenir une localisation du faisceau lumineux capturé par la structure dans une zone centrale 31 correspondant à la zone active. On améliore ainsi le rapport signal à bruit, ce qui est le but recherché.

Selon les deux axes Ox et Oy perpendiculaires entre eux et parallèles au plan de la face inférieure, la fonction mathématique définissant l'épaisseur optique de la structure est la somme de deux fonctions périodiques g(x, y) et f(x, y), f représentant la fonction de couplage de période spatiale Λ et g représentant la fonction de Bragg de localisation de période spatiale 2Λ comportant un défaut central. La phase relative entre f et g conditionne les propriétés finales de confinement de l'onde couplée. Si on note λ la longueur d'onde moyenne du rayonnement incident, avantageusement, le pas Λ doit être égal à λ/2n pour obtenir un couplage optimal de l'onde d'incidence.

Les fonctions périodiques les plus simples sont les fonctions trigonométriques sinus et cosinus. Dans ce cas, les fonctions *f* et *g* peuvent être définies de la manière suivante : $f \left(x , y\right) = \pm {a}_{1} sin \left(\frac{2 π}{Λ} \left(x - y\right)\right)$ et $g \left(x , y\right) = - {a}_{2} \left[cos \left(\frac{4 π}{Λ} | x | \pm \frac{π}{2}\right) + cos \left(\frac{4 π}{Λ} | y | \pm \frac{π}{2}\right)\right]$ Les constantes a₁ et a₂ sont positives, les signes + ou - placés devant a₁ sont liés à deux implémentations possibles de la structure. Comme il a été dit pour les structures monodimensionnelles, toutes fonctions *f̃* et *g̃* ayant le même contenu spectral à l'ordre 1/Λ et à l'ordre 2/Λ que les fonctions f et g auront des caractéristiques de couplage et de confinement voisines.

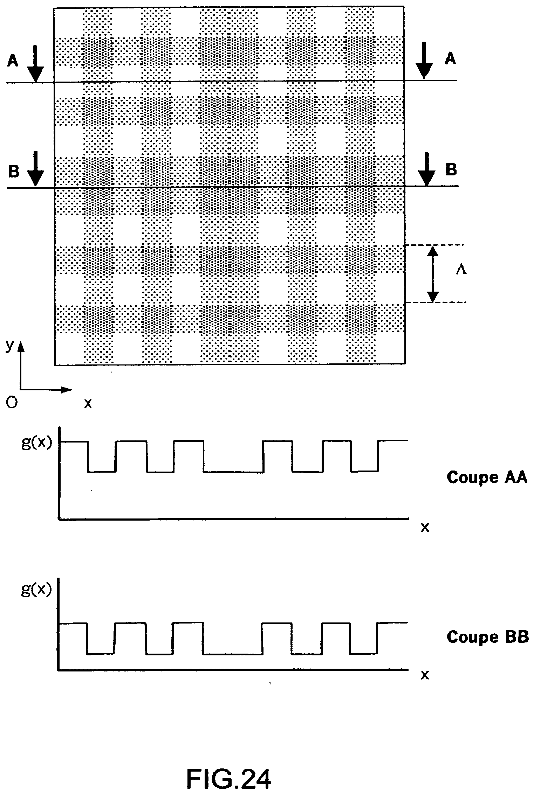

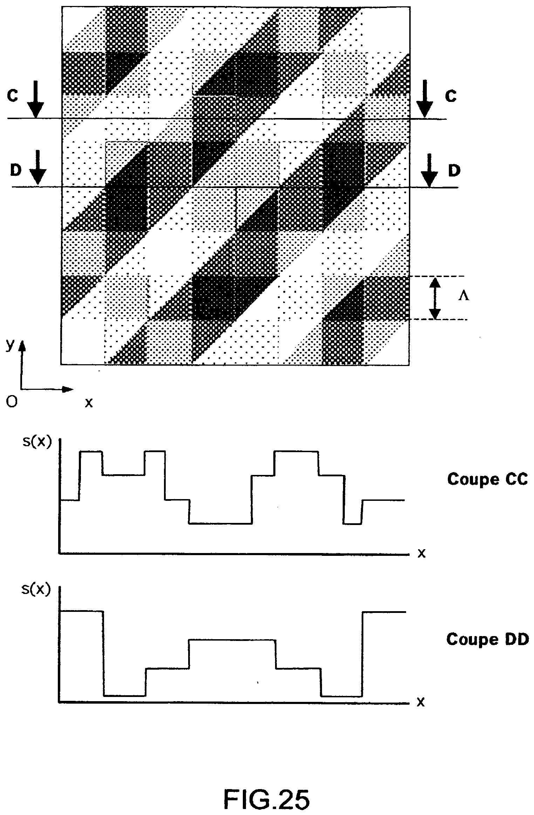

Technologiquement, les structures simples à réaliser sont constituées de « marches d'escalier » ou de facettes obtenues par l'empilement de couches successives. Mathématiquement, pour obtenir ce type de profil s(x,y), on peut également remplacer les fonctions f et *g* par les fonctions *signe(f)* et *signe(g).* Ainsi, les figures 24 et 25 représentent en vue de dessus et les vues en coupe des fonctions : ${g}^{˜} \left(x , y\right) = - {a}_{2} \left[signe \left(cos \left(\frac{4 π}{Λ} | x | + \frac{π}{2}\right)\right) + signe \left(cos \left(\frac{4 π}{Λ} | y | + \frac{π}{2}\right)\right)\right]$ ${s}^{˜} \left(x , y\right) = {f}^{˜} \left(x , y\right) + {g}^{˜} \left(x , y\right) = {a}_{1} \left[signe \left(cos \left(\frac{2 π}{Λ} \left(x - y\right)\right)\right)\right] + {g}^{˜} \left(x , y\right)$

Autrement dit, l'épaisseur optique de la structure séparant la face inférieure de la face supérieure selon deux axes perpendiculaires entre eux, parallèles au plan de la face inférieure et dont l'origine commune est centrée sur le centre du réseau varie selon une fonction qui est la somme ou la différence :
- d'une première fonction proportionnelle à la fonction signe d'une première fonction cosinus de la valeur absolue de la distance à l'origine proportionnelle à la fonction signe de la fonction cosinus premier axe, ladite première fonction cosinus étant déphasée de plus ou moins 90 degrés par rapport à l'origine ;
- d'une seconde fonction proportionnelle à la fonction signe de la fonction cosinus de la valeur absolue de la distance à l'origine selon l'axe perpendiculaire audit premier axe, de période identique à celle de la première fonction, ladite seconde fonction cosinus étant déphasée de plus ou moins 90 degrés par rapport à l'origine ;
- d'une troisième fonction proportionnelle à la fonction signe de la fonction sinus de la différence des distances à l'origine selon le premier axe et le second axe.

Sur la vue de dessus de la fonction *g̃*(x,*y*) représentée en figure 24, les différences de niveau entre les marches d'escalier sont représentées par des niveaux de gris de plus en plus clairs au fur et à mesure que le niveau est élevé. Le profil de la fonction selon deux coupes AA et BB est représenté sous la vue de dessus.

Sur la vue de dessus de la fonction *s̃*(*x*,*y*) représentée en figure 25, les différences de niveau entre les marches d'escalier sont représentées par des niveaux de gris de plus en plus clair au fur et à mesure que le niveau est élevé. Le profil de la structure selon deux coupes CC et BB est représentée sous la vue de dessus.

Cette invention s'applique avantageusement aux détecteurs de type QWIPs (Quantum Well Infrared Photodetector), les structures métalliques selon l'invention sont appliquées au-dessus de la zone active de ces composants. La zone active est placée le plus près possible de la structure et en correspondance avec le défaut de ladite structure.

L'invention s'applique également à des détecteurs d'autre type, comme par exemple les photodétecteurs ou photoconducteurs inter-bande basés sur les familles de matériaux de type GaSb (Antimoniure de Gallium) ou HgCdTe (Mercure Cadmium Tellure).

La zone active du composant doit être limitée à une petite région au-dessous du défaut. La limitation de la zone active peut impliquer :
- la neutralisation des puits quantiques par implantation ;
- la limitation du courant par neutralisation du dopage dans la couche contact dans le cas de systèmes photoconducteurs.

Les structures selon l'invention peuvent être utilisées dans d'autres domaines spectraux comme les micro-ondes dont les fréquences sont de l'ordre du gigahertz, comme le domaine de l'infrarouge lointain dont les fréquences sont de l'ordre du térahertz ou le domaine du proche infrarouge.

L'invention s'applique également aux matrices photosensibles comprenant une pluralité de photo-détecteurs selon l'invention organisés en lignes et en colonnes.

## Revendications

1. Photo-détecteur (10) comprenant :
• au moins une zone active (31) de détection d'un rayonnement infrarouge et
• une structure (4) disposée sur ladite zone active (31) destinée au couplage optique du rayonnement infrarouge, ladite structure (4) cumulant les propriétés des réseaux de couplage et des réseaux de Bragg et présentant au moins un défaut, permettant d'obtenir, à partir d'une onde incidente, une onde plasmonique qui soit à la fois couplée et localisée dans la zone active (31),
• ladite zone active étant de dimensions petites par rapport à celles de ladite structure, et ladite zone active étant de forme allongée,
• ladite structure étant composée de sillons parallèles entre eux et parallèles à la longueur de ladite zone active (31),
• la structure (4) étant réalisée dans une couche (41) d'au moins un matériau diélectrique transparent dans la plage spectrale du rayonnement infrarouge, ladite couche (41) comprenant une face inférieure (410) sensiblement plane en contact avec la zone active et une face supérieure (411) comportant les sillons de la structure (4), ladite face supérieure (411) étant recouverte d'une pellicule de métal (43), l'épaisseur optique de la dite couche (41) séparant la face inférieure (410) de la face supérieure (411) selon un axe (Ox) perpendiculaire à la direction des sillons et parallèle au plan de la face inférieure (410) variant comme la superposition au moins d'un premier réseau dit de couplage, dont le pas est à une première fréquence spatiale et d'un second réseau dit de localisation, dont le pas est à une seconde fréquence spatiale double de la première fréquence spatiale et comportant un défaut spatial central.

2. Photo-détecteur (10) selon la revendication 1, **caractérisé en ce que** la couche (41) constituant la structure est réalisée dans un matériau diélectrique isotrope et que le profil de chaque sillon selon l'axe perpendiculaire à la direction des sillons est composé de facettes planes de hauteur différente et parallèles entre elles.

3. Photo-détecteur (10) selon la revendication 1, **caractérisé en ce que** la couche (41) constituant la structure est réalisée dans un matériau composé de couches alternées (412,413) parallèles entre elles et de même épaisseur et d'une couche centrale d'épaisseur double, lesdites couches comprenant alternativement un premier matériau ayant une première permittivité et un second matériau ayant une seconde permittivité, le plan des couches étant perpendiculaire au plan de la face inférieure, et **en ce que** le profil de chaque sillon selon l'axe perpendiculaire à la direction des sillons est composé de créneaux réguliers d'un pas deux fois supérieur à l'épaisseur des couches alternées..

4. Photo-détecteur (10) selon l'une des revendications 1 à 3, **caractérisé en ce que** l'épaisseur optique de ladite couche (41) séparant la face inférieure de la face supérieure varie, selon un axe (Ox) perpendiculaire à la direction des sillons, parallèle au plan de la face inférieure et dont l'origine est centrée sur le centre du réseau, comme une fonction qui est la somme ou la différence :
• d'une première fonction proportionnelle à la fonction signe de la fonction cosinus de la distance à l'origine dudit axe et de période égale à celle du pas des sillons ;
• d'une seconde fonction proportionnelle à la fonction signe de la fonction cosinus de la valeur absolue de la distance à l'origine dudit axe, de période égale à la moitié de celle du pas des sillons, ladite seconde fonction déphasée d'une demi-période par rapport à la première fonction.

5. Photo-détecteur (10) selon l'une des revendications 1 à 3, **caractérisé en ce que** l'épaisseur optique de la dite couche (41) séparant la face inférieure de la face supérieure varie, selon un axe (Ox) perpendiculaire à la direction des sillons, parallèle au plan de la face inférieure et dont l'origine est centrée sur le centre du réseau, comme une fonction qui est la somme ou la différence :
• d'une première fonction proportionnelle à la fonction signe de la fonction sinus de la distance à l'origine dudit axe et de période égale à celle du pas des sillons ;
• d'une seconde fonction proportionnelle à la fonction signe de la fonction cosinus de la valeur absolue de la distance à l'origine dudit axe, de période égale à la moitié de celle du pas des sillons, ladite seconde fonction déphasée d'une demi-période par rapport à la première fonction.

6. Photo-détecteur (10) selon l'une des revendications 4 ou 5, **caractérisé en ce que** le coefficient de proportionnalité de la première fonction est le double de celui de la deuxième fonction.

7. Photo-détecteur (10) selon l'une des revendications précédentes, **caractérisé en ce que** le pas du premier réseau de la structure est environ égal à la moitié de la longueur d'onde moyenne du rayonnement incident divisé par l'indice optique moyen de la structure.

8. Photo-détecteur (10) selon l'une des revendications précédentes, **caractérisé en ce que** la zone active (31) est entourée d'une zone optiquement passive (32), la largeur de l'ensemble constitué par la zone active (31) et la zone passive (32) étant sensiblement égale à la largeur de la structure (4).

9. Photo-détecteur (10) selon la revendication 8, **caractérisé en ce que** la zone active (31) est une structure à puits quantiques.

10. Photo-détecteur (10) à structure bidimensionnelle comprenant :
• au moins une zone active (31) de détection d'un rayonnement infrarouge et
• une structure bidimensionnelle (4) disposée sur ladite zone active (31) destinée au couplage optique du rayonnement infrarouge, ladite structure (4) cumulant les propriétés des réseaux de couplage et des réseaux de Bragg et présentant au moins un défaut, permettant d'obtenir, à partir d'une onde incidente, une onde plasmonique qui soit à la fois couplée et localisée dans la zone active (31),
• ladite structure étant composée de motifs de dimensions sensiblement identiques (R8 + page 16 lignes 6-7),
• ladite zone active étant centrée sur ladite structure et les dimensions de ladite zone active étant sensiblement égales aux dimensions moyennes des motifs (R8 + page 16 lignes 7-9),
la structure (4) étant réalisée dans une couche (41) d'au moins un matériau diélectrique transparent dans la plage spectrale du rayonnement infrarouge, ladite couche comprenant une face inférieure (410) sensiblement plane en contact avec la zone active et une face supérieure (411) comportant les motifs de la structure, ladite face recouverte d'une pellicule de métal (43), l'épaisseur optique de la dite couche séparant la face inférieure de la face supérieure variant :
• selon un premier axe parallèle au plan de la face inférieure, comme au moins un premier réseau dont le pas est à une première fréquence spatiale ;
• selon un second axe perpendiculaire au premier axe et parallèle au plan de la face inférieure, comme au moins un second réseau dont le pas est à la même première fréquence spatiale ;
• selon un troisième axe oblique à 45 degrés des deux précédents, comme au moins un troisième réseau dont le pas est à une seconde fréquence spatiale égale à la moitié de la première fréquence spatiale.

11. Photo-détecteur (10) selon la revendication 10, **caractérisé en ce que**, lorsque la couche (41) constituant la structure est réalisée dans un matériau diélectrique isotrope, chaque motif est composé de facettes planes de hauteur différente et parallèles entre elles.

12. Photo-détecteur (10) selon la revendication 10, **caractérisé en ce que** l'épaisseur optique de ladite structure (4) séparant la face inférieure de la face supérieure varie, selon deux axes perpendiculaires entre eux, parallèles au plan de la face inférieure et dont l'origine commune est centrée sur le centre de la structure, comme une fonction qui est la somme ou la différence :
• d'une première fonction proportionnelle à la fonction signe d'une première fonction cosinus de la valeur absolue de la distance à l'origine proportionnelle à la fonction signe de la fonction cosinus premier axe, ladite première fonction cosinus étant déphasée de plus ou moins 90 degrés par rapport à l'origine ;
• d'une seconde fonction proportionnelle à la fonction signe de la fonction cosinus de la valeur absolue de la distance à l'origine selon l'axe perpendiculaire audit premier axe, de période identique à celle de la première fonction, ladite seconde fonction cosinus étant déphasée de plus ou moins 90 degrés par rapport à l'origine ;
• d'une troisième fonction proportionnelle à la fonction signe de la fonction sinus de la différence des distances à l'origine selon le premier axe et le second axe.

13. Photo-détecteur (10) selon l'une des revendications 10 à 11, **caractérisé en ce que** les dimensions des motifs de la structure sont environ égales à la moitié de la longueur d'onde moyenne du rayonnement incident divisé par l'indice optique moyen de la structure.

14. Photo-détecteur (10) selon l'une des revendications 10 à 13, **caractérisé en ce que** la zone active (31) est entourée d'une zone optiquement passive (32), la largeur de l'ensemble constitué par la zone active (31) et la zone passive (32) étant sensiblement égale à la largeur de la structure (4),la zone active (31) étant une structure à puits quantiques.

15. Matrice photosensible comprenant une pluralité de photodétecteurs organisés en lignes et en colonnes, **caractérisée en ce que** lesdits photo-détecteurs sont selon l'une des revendications précédentes.

## Patentansprüche

1. Fotodetektor (10) umfassend:
• mindestens eine aktive Erfassungszone (31) einer Infrarot-Strahlung und
• eine auf dieser aktiven Zone (31) angeordnete Struktur, zur optischen Kopplung der Infrarot-Strahlung, wobei diese Struktur (4) die Eigenschaften der Koppelnetzwerke und der Bragg- Netzwerke kumuliert und mindestens einen Standartwert aufweist, mit dem, ausgehend von einer einfallenden Welle, eine Plasmonenwelle, erzeugt wird, die gleichzeitig in der aktiven Zone (31) gekoppelt und lokalisiert ist.
• diese aktive Zone hat kleinere Maße als die genannte Struktur und diese aktive Zone hat eine längliche Form,
• diese Struktur besteht aus zueinander parallelen und zu dieser aktiven Zone (31) parallelen Rillen,
• die Struktur (4) wird ausgeführt aus einer Schicht (41) aus mindestens einem dielektrischen Material, transparent im Spektralbereich der Infrarot-Strahlung, diese Schicht (41) umfasst eine Unterseite (410), im Wesentlichen eben, in Kontakt mit der aktiven Zone und eine Oberseite (411), die die Rillen der Struktur (4) enthält, diese Oberseite (411) ist bedeckt mit einem Metallfilm (43), die optische Dicke dieser Schicht (41), die die Unterseite (410) von der Oberseite (411) trennt, entlang einer Achse (Ox), senkrecht zur Richtung der Rillen und parallel zur Ebene der Unterseite (410), verändert sich wie das Übereinanderlegen mindestens eines ersten, sogenannten Kopplungsnetzwerks, dessen Schritt einer ersten Ortsfrequenz entspricht und eines zweiten sogenannten Lokalisierungsnetzwerks, dessen Schritt bei einer zweiten Ortsfrequenz liegt, dem Doppelten der ersten Ortsfrequenz, und einen zentralen Standardwert enthaltend.

2. Fotodetektor (10) gemäß Anspruch 1, **dadurch gekennzeichnet, dass** die Schicht (41), die die Struktur bildet, aus einem isotropen, dielektrischen Material ausgeführt wird und dass das Profil jeder Rille entlang der Achse senkrecht zur Richtung der Rillen, aus ebenen und zueinander parallelen Facetten unterschiedlicher Höhe besteht.

3. Fotodetektor (10) gemäß Anspruch 1, **dadurch gekennzeichnet, dass** die Schicht (41), die die Struktur bildet, aus einem Material besteht, das aus alternierenden, zueinander parallelen Schichten (412, 413) derselben Dicke und einer mittleren Schicht mit doppelter Dicke gebildet wird, diese Schichten umfassen abwechseln ein erstes Material mit einer ersten Permittivität und ein zweites Material mit einer zweiten Permittivität, die Ebene der Schichten liegt senkrecht zur Ebene der Unterseite, und dadurch, dass das Profil jeder Rillen entlang der senkrecht zur Richtung der Rillen aus regelmäßigen Nischen besteht mit einem Schritt, der zwei Mal höher ist als die Dicke der abwechselnden Schichten.

4. Fotodetektor (10) gemäß einem der Ansprüche 1 bis 3, **dadurch gekennzeichnet, dass** die optische Dicke dieser Schicht (41), die die Unterseite von der Oberseite trennt, sich entsprechend einer Achse (Ox), senkrecht zur Richtung der Rillen, parallel zur Ebene der Unterseite verändert und deren Ursprung in der Netzwerkmitte zentriert ist, wie eine Funktion, die die Summe oder Differenz ist:
• einer ersten Funktion, proportional zur Signumfunktion der Cosinus-Funktion des Abstandes zum Ursprung dieser Achse und mit gleicher Periode wie die der Schritt der Rillen;
• einer zweiten Funktion, proportional zur Signumfunktion der Cosinus-Funktion des absoluten Wertes des Abstandes zum Ursprung dieser Achse und mit einer Periode gleich der Hälfte des Schritts der Rillen, diese zweite Funktion ist um eine halbe Periode phasenversetzt, bezogen auf die erste Funktion.

5. Fotodetektor (10) gemäß einem der Ansprüche 1 bis 3, **dadurch gekennzeichnet, dass** die optische Dicke dieser Schicht (41), die die Unterseite von der Oberseite trennt, sich entsprechend einer Achse (Ox), senkrecht zur Richtung der Rillen, parallel zur Ebene der Unterseite verändert und deren Ursprung in der Netzwerkmitte zentriert ist, wie eine Funktion, die die Summe oder Differenz ist:
• einer ersten Funktion, proportional zur Signumfunktion der Sinus-Funktion des Abstandes zum Ursprung dieser Achse und mit gleicher Periode wie die der Schritt der Rillen;
• einer zweiten Funktion, proportional zur Signumfunktion der Cosinus-Funktion des absoluten Wertes des Abstandes zum Ursprung dieser Achse und mit einer Periode gleich der Hälfte des Schritts der Rillen, diese zweite Funktion ist um eine halbe Periode phasenversetzt, bezogen auf die erste Funktion.

6. Fotodetektor (10) gemäß einem der Ansprüche 4 oder 5, **dadurch gekennzeichnet, dass** der Proportionalitätsfaktor der ersten Funktion das Doppelte des der zweiten Funktion ist.

7. Fotodetektor (10) gemäß irgendeinem der vorangehenden Ansprüche, **dadurch gekennzeichnet, dass** der Schritt des ersten Netzwerks der Struktur ungefähr gleich der Hälfte der durchschnittlichen Wellenlänge der einfallenden Strahlung, geteilt durch den durchschnittlichen Brechungsindex der Struktur ist.

8. Fotodetektor (10) gemäß irgendeinem der vorangehenden Ansprüche, **dadurch gekennzeichnet, dass** die aktive Zone (31) von einer optisch passiven Zone (32) umgeben ist, die Breite der Einheit aus aktiver Zone (31) und passiver Zone (32) ist im Wesentlichen gleich der Breite der Struktur (4).

9. Fotodetektor (10) gemäß Anspruch 8, **dadurch gekennzeichnet, dass** die aktive Zone (31) eine Quantentopfstruktur ist.

10. Fotodetektor (10) mit zweidimensionaler Struktur, umfassend:
• mindestens eine aktive Erfassungszone (31) einer Infrarot-Strahlung und
• eine auf dieser aktiven Zone (31) angeordnete zweidimensionale Struktur (4) zur optischen Kopplung der Infrarot-Strahlung, diese Struktur (4) kumuliert die Eigenschaften der Koppelnetzwerke und der Bragg- Netzwerke und weisen mindestens einen Standartwert auf, mit dem ausgehend von einer einfallenden Welle eine Plasmonenwelle, erzeugt wird, die gleichzeitig in der aktiven Zone (31) gekoppelt und lokalisiert ist.
• diese Struktur besteht aus Mustern mit im Wesentlichen identischen Abmessungen (R8 + Seite 16 Zeilen 6-7),
• diese aktive Zone ist auf dieser Struktur zentriert und die Maße dieser aktiven Zone sind im Wesentlichen gleich den durchschnittlichen Maßen der Muster (R8 + Seite 16 Zeilen 7-9),
die Struktur (4) ist ausgeführt aus einer Schicht (41) aus mindestens einem dielektrischen Material, transparent im Spektralbereich der Infrarot-Strahlung, diese Schicht (41) umfasst eine Unterseite (410), im Wesentlichen eben, in Kontakt mit der aktiven Zone und eine Oberseite (411), die die Rillen der Struktur enthält, diese Oberseite ist bedeckt mit einem Metallfilm (43), die optische Dicke dieser Schicht, die die Unterseite von der Oberseite trennt, verändert sich:
• gemäß einer ersten Achse, parallel zur Ebene der Unterseite, wie mindestens ein erstes Netzwerk, dessen Schritt eine erste Ortsfrequenz hat;
• gemäß einer zweiten Achse, senkrecht zur ersten Achse und parallel zur Ebene der Unterseite, wie mindestens ein zweites Netzwerk, dessen Schritt dieselbe erste Ortsfrequenz hat;
• gemäß einer dritten, um 45 Grad gegenüber den beiden vorangehenden geneigten Achse, wie mindestens ein drittes Netzwerks mit einem Schritt einer zweiten Ortsfrequenz, gleich der Hälfte der ersten Ortsfrequenz.

11. Fotodetektor (10) gemäß Anspruch 10, **dadurch gekennzeichnet, dass** die Schicht (41), die die Struktur bildet, aus einem isotropen, dielektrischen Material ausgeführt wird, und dass jedes Muster aus ebenen und zueinander parallelen Facetten unterschiedlicher Höhe besteht.

12. Fotodetektor (10) gemäß Anspruch 10, **dadurch gekennzeichnet, dass** die optische Dicke dieser Schicht (4), die die Unterseite von der Oberseite trennt, sich entsprechend zwei zueinander senkrechten Achsen, parallel zur Ebene der Unterseite verändert und deren gemeinsamer Ursprung in der Netzwerkmitte zentriert ist, wie eine Funktion, die die Summe oder Differenz ist:
• einer ersten Funktion, proportional zur Signumfunktion einer ersten Cosinus-Funktion des absoluten Wertes des Abstandes zum Ursprung dieser Achse, proportional zur Signumfunktion der Cosinus-Funktion erste Achse, diese erste Cosinus-Funktion ist um mehr oder weniger 90 Grad bezogen auf den Ursprung phasenversetzt.
• einer zweiten Funktion, proportional zur Signumfunktion der Cosinus-Funktion des absoluten Wertes des Abstandes zum Ursprung dieser Achse, nach der senkrechten Achse zu dieser ersten Achse, deren Periode identisch ist mit der der ersten Funktion, diese zweite Cosinus-Funktion ist um mehr oder weniger 90 Grad bezogen auf den Ursprung phasenversetzt.
• einer dritten Funktion, proportional zur Signumfunktion der Sinus-Funktion der Differenz der Abstände vom Ursprung nach der ersten Achse und der zweiten Achse.

13. Fotodetektor (10) gemäß irgendeinem der Ansprüche 10 bis 11, **dadurch gekennzeichnet, dass** die Maße der Muster der Struktur ungefähr gleich der Hälfte der durchschnittlichen Wellenlänge der einfallenden Strahlung, geteilt durch den durchschnittlichen Brechungsindex der Struktur sind.

14. Fotodetektor (10) nach einem der Ansprüche 10 bis 13, **dadurch gekennzeichnet, dass** die aktive Zone (31) von einer optisch passiven Zone (32) umgeben ist, die Breite der Einheit aus aktiver Zone (31) und passiver Zone (32) ist im Wesentlichen gleich der Breite der Struktur (4), bei der aktiven Zone (31) handelt es sich um eine Quantentopfstruktur.

15. Fotosensible Matrix, umfassend mehrere Fotodetektoren, die in Reihen oder Spalten organisiert sind, **dadurch gekennzeichnet, dass** diese Fotodetektoren einem der vorangehenden Ansprüche entsprechen.

## Claims

1. Photodetector (10) incorporating:
• at least one active area (31) for detecting optical radiation and
• one structure (4), positioned on the said active area (31), designed for optically coupling of infrared radiation, **characterized by** the fact that the said structure combines the properties of coupling gratings and Bragg gratings, and has at least one defect which, from an incident wave, makes it possible to obtain a plasmon wave which is both coupled and localized in the active area, with the said active area (31) having dimensions that are small in comparison to those of the said structure;
• with the said active area (31) being of small dimensions in relation to those of the aforesaid structure, and with the said active area being elongated in form;
• with the said structure being composed of mutually-parallel grooves parallel to the length of the said active area (31);
• with the structure (4) being produced in a layer (41) of at least one dielectric material transparent in the spectral range of the infrared radiation, with the said layer (41) incorporating one essentially-flat lower face (410) in contact with the active area, and one upper face (411) incorporating the grooves of the structure (4), with the said upper face (411) being covered with a metal film (43), with the optical thickness of the said layer (41) separating the lower face (410) from the upper face (411) along an axis (Ox) perpendicular to the direction of the grooves, and parallel to the plane of the lower face (410) varying with the superimposition of at least one first so-called coupling grating, of which the pitch is at a first spatial frequency, and a second so-called localization grating, of which the pitch is at a second spatial frequency that is twice the first spatial frequency and incorporates a first central defect.

2. Photodetector (10) in accordance with claim 1, **characterized by** the fact that the layer (41) constituting the structure is manufactured in an isotropic dielectric material, and by the fact that the profile of each groove in the axis perpendicular to the direction of the grooves is composed of mutually-parallel flat facets of different height.

3. Photodetector (10) in accordance with claim 3, **characterized by** the fact that the layer (41) constituting the structure is made from a material composed of mutually parallel alternate layers (412, 413) of equal thickness and a central layer of double thickness, with the said layers alternately incorporating a first material having a first permittivity and a second material having a second permittivity, with the plane of the layers being perpendicular to the plane of the lower face, and by the fact that the profile of each groove along the axis perpendicular to the direction of the grooves is composed of regular crenellations with a pitch two times greater than the thickness of the alternate layers.

4. Photodetector (10) in accordance with one of claims 1 to 3, **characterized by** the fact that the optical thickness of the said layer (41) separating the lower face from the upper face varies along an axis (Ox) perpendicular to the direction of the grooves, and parallel to the plane of the lower face, of which the origin is centered on the center of the grating, as a function which is the sum of or the difference of:
• a first function proportional to the sign function of the cosine function of the distance to the origin of the said axis, and having a period equal to that of the pitch of the grooves;
• a second function proportional to the sign function of the cosine function of the absolute value of the distance to the origin of said axis, and having a period equal to half that of the pitch of the grooves, with the said second function being phase-shifted by one half-period in relation to the first function.

5. Photodetector (10) in accordance with one of claims 1 to 3, **characterized by** the fact that the optical thickness of the said layer (41) separating the lower face from the upper face varies along an axis (Ox) perpendicular to the direction of the grooves, and parallel to the plane of the lower face, of which the origin is centered on the center of the grating, as a function which is the sum of or the difference of:
• a first function proportional to the sign function of the sine function of the distance to the origin of the said axis, and having a period equal to that of the pitch of the grooves;
• a second function proportional to the sign function of the cosine function of the absolute value of the distance to the origin of the said axis, and having a period equal to half that of the pitch of the grooves, with the said second function being phase-shifted by one half-period in relation to the first function.

6. Photodetector (10) in accordance with one of claims 4 and 5, **characterized by** the fact that the proportionality coefficient of the first function is two times that of the second function.

7. Photodetector (10) in accordance with one of the preceding claims, **characterized by** the fact that the pitch of the first grating of the structure is approximately equal to half the average wavelength of the incident radiation, divided by the average optical index of the structure.

8. Photodetector (10) in accordance with one of the preceding claims, **characterized by** the fact that the active area (31) is surrounded by an optically-passive area (32), with the width of the ensemble constituted by the active area (31) and the passive area (32) being substantially equal to the width of the structure (4).

9. Photodetector (10) in accordance with claim 8, **characterized by** the fact that the active area (31) is a quantic well structure.

10. Photodetector (10) with a two-dimensional structure incorporating:
• at least one active area (31) for detecting infrared radiation; and
• a two-dimensional structure (4) positioned on the said active area (31) designed for optically coupling of the infrared radiation, with the said structure (4) combining the properties of coupling gratings and Bragg gratings, and having at least one defect, allowing one to obtain from an incident wave a plasmon wave that is both coupled and localized in the active area (31);
• with the said structure being composed of patterns of essentially-identical dimensions (R8 + page 16, lines 7-9);
• with the said active area being centered on said structure and the dimensions of said active zone being essentially-identical to the average dimensions of the patterns (R8 + page 16, lines 7-9);
with the structure (4) being produced in a layer (4) of at least one dielectric material transparent in the spectral range of the infrared radiation, with the said layer incorporating one essentially-flat lower face (410) in contact with the active area, and one upper face (411) incorporating the patterns of the structure, with the said face being covered with a metal film (43), and with the optical thickness of the said layer separating the lower face from the upper face varying:
• along a first axis parallel to the plane of the lower face, with at least one grating of which the pitch is at a first spatial frequency;
• along a second axis perpendicular to the first axis and parallel to the plane of the lower axis, with at least one second grating of which the pitch is at the same spatial frequency as the first;
• along a third axis obliquely positioned at 45 degrees from the preceding two, with at least one third grating of which the pitch is at a second spatial frequency equal to half the first spatial frequency.

11. The photodetector (10) as claimed in claim 10, **characterized in that** the layer (41) comprising the structure is produced in an isotropic dielectric material; each pattern is composed of flat facets of varying height, parallel to each other.

12. Photodetector (10) in accordance with claim 10, **characterized by** the fact that the optical thickness of said structure (4) separating the lower face from the upper face varies along two mutually-perpendicular axes that are parallel to the plane of the lower face, and of which the common origin is centered on the center of the structure, as a function which is the sum of or the difference of:
• a first function proportional to the sign function of a first cosine function of the absolute value of the distance to the origin proportional to the sign function of the cosine function, first axis, with the said first cosine function being phase-shifted by plus or minus 90 degrees in relation to the origin;
• a second function proportional to the sign function of the cosine function of the absolute value of the distance to the origin, along the axis perpendicular to the said first axis, and having a period identical to that of the first function, with the said second cosine function being phase-shifted by plus or minus 90 degrees in relation to the origin;
• a third function proportional to the sign function of the sine function of the difference between the distances to the origin, along the first axis and the second axis.

13. Photodetector (10) in accordance with one of claims 10 and 11, **characterized by** the fact that the dimensions of the patterns of the structure are approximately equal to half the average wavelength of the incident radiation, divided by the average optical index of the structure.

14. Photodetector (10) in accordance with one of claims 10 to 13, **characterized by** the fact that the active area (31) is surrounded by an optically-passive area (32) with dimensions substantially equal to those of the structure (4), and with the active area (31) being a quantic well structure.

15. Photosensitive matrix incorporating multiple photodetectors organized in lines and columns, **characterized by** the fact that the said photodetectors are in accordance with one of the preceding claims.
